(19) Europäisches Patentamt / European Patent Office / Office européen des brevets

(11) **EP 4 495 666 A1**

(12) **EUROPEAN PATENT APPLICATION**
published in accordance with Art. 153(4) EPC

(43) Date of publication:
**22.01.2025 Bulletin 2025/04**

(21) Application number: **23770581.9**

(22) Date of filing: **08.03.2023**

(51) International Patent Classification (IPC):
***G02B 27/02*** *(2006.01)* ***G02B 3/00*** *(2006.01)*
***G02B 5/00*** *(2006.01)* ***G02B 5/08*** *(2006.01)*
***G02B 5/30*** *(2006.01)* ***G02B 13/00*** *(2006.01)*
***G02B 17/08*** *(2006.01)* ***G02C 7/00*** *(2006.01)*
***G02F 1/13*** *(2006.01)* ***G02F 1/13363*** *(2006.01)*
***G02F 1/1337*** *(2006.01)* ***G09F 9/00*** *(2006.01)*
***H04N 5/64*** *(2006.01)* ***H04N 5/66*** *(2006.01)*
***H04N 13/344*** *(2018.01)* ***H04N 13/346*** *(2018.01)*
***H05B 33/02*** *(2006.01)* ***H05B 33/10*** *(2006.01)*
***H05B 33/24*** *(2006.01)* ***H10K 50/00*** *(2023.01)*
***H10K 59/00*** *(2023.01)*

(52) Cooperative Patent Classification (CPC):
**G02B 3/00; G02B 5/00; G02B 5/08; G02B 5/30; G02B 13/00; G02B 17/08; G02B 27/02; G02C 7/00; G02F 1/13; G02F 1/13363; G02F 1/1337; G09F 9/00; H04N 5/64; H04N 5/66; H04N 13/344;**
(Cont.)

(86) International application number:
**PCT/JP2023/008810**

(87) International publication number:
**WO 2023/176625 (21.09.2023 Gazette 2023/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:
**14.03.2022 JP 2022039285**
**14.03.2022 JP 2022039286**
**10.05.2022 JP 2022077631**
**10.05.2022 JP 2022077632**
**10.05.2022 JP 2022077633**
**10.05.2022 JP 2022077634**
**10.05.2022 JP 2022077657**
**10.05.2022 JP 2022077658**
**10.05.2022 JP 2022077659**
**10.05.2022 JP 2022077676**
**10.05.2022 JP 2022077677**
**10.05.2022 JP 2022077678**
**10.05.2022 JP 2022077679**
**28.12.2022 JP 2022212217**

(71) Applicant: **Nitto Denko Corporation**
**Ibaraki-shi, Osaka 567-8680 (JP)**

(72) Inventors:
- **NAMBARA, Takuya**
**Ibaraki-shi, Osaka 567-8680 (JP)**
- **GOTO, Shusaku**
**Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

# (54) LENS PART, DISPLAY BODY, AND DISPLAY METHOD

(57) Provided is a lens unit that can achieve a reduction in weight of a pair of VR goggles and an improvement in viewability thereof. The lens unit according to one embodiment of the present invention is a lens unit to be used in a display system configured to display an image to a user, the lens unit including: a reflection-type polarizing member configured to reflect light, which has been emitted to a front side from a display surface of a display element configured to display the image, and has passed through a polarizing member and a first λ/4 member; a first lens portion arranged on an optical path between the display element and the reflection-type po-



EP 4 495 666 A1

larizing member; a half mirror arranged between the display element and the first lens portion, the half mirror being configured to transmit the light emitted from the display element and to reflect the light reflected by the reflection-type polarizing member toward the reflection-type polarizing member; a second lens portion arranged on the front side of the reflection-type polarizing member; and a second λ/4 member arranged on an optical path between the half mirror and the reflection-type polarizing member, wherein an assembly formed by arranging three first laminate portions each including the second λ/4 member and at least one pressure-sensitive adhesive layer has an ISC value of 100 or less.

FIG. 1

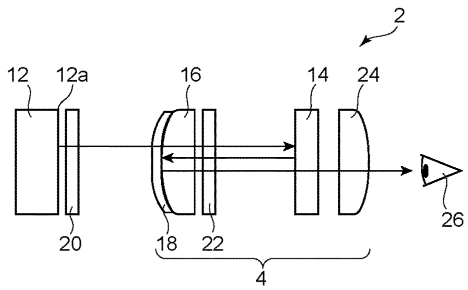


(52) Cooperative Patent Classification (CPC): (Cont.)
**H04N 13/346; H05B 33/02; H05B 33/10; H05B 33/24; H10K 50/00; H10K 59/00**

## Description

Technical Field

The present invention relates to a lens unit, a display body, and a display method.

Background Art

Image display apparatus typified by a liquid crystal display apparatus and an electroluminescence (EL) display apparatus (e.g., an organic EL display apparatus) have been rapidly gaining more widespread use. In the image display apparatus, an optical member, such as a polarizing member or a retardation member, has been generally used for achieving image display and improving the performance of the image display (see, for example, Patent Literature 1).

In recent years, new applications of the image display apparatus have been developed. For example, a pair of goggles (VR goggles) with a display for achieving virtual reality (VR) has started to be commercialized. A reduction in weight of the pair of VR goggles, an improvement in viewability thereof, and the like have been desired because an investigation has been made on the utilization of the pair of VR goggles in various fields. The weight reduction may be achieved by, for example, thinning a lens to be used in the pair of VR goggles. Meanwhile, the development of an optical member suitable for a display system using a thin lens has also been desired.

Citation List

Patent Literature

[PTL 1] JP 2021-103286 A

Summary of Invention

Technical Problem

In view of the foregoing, a primary object of the present invention is to provide a lens unit that can achieve a reduction in weight of a pair of VR goggles and an improvement in viewability thereof.

Solution to Problem

1. According to one embodiment of the present invention, there is provided a lens unit to be used in a display system configured to display an image to a user, the lens unit including: a reflection-type polarizing member configured to reflect light, which has been emitted to a front side from a display surface of a display element configured to display the image, and has passed through a polarizing member and a first λ/4 member; a first lens portion arranged on an optical path between the display element and the reflection-type polarizing 2 member; a half mirror arranged between the display element and the first lens portion, the half mirror being configured to transmit the light emitted from the display element and to reflect the light reflected by the reflection-type polarizing member toward the reflection-type polarizing member; a second lens portion arranged on the front side of the reflection-type polarizing member; and a second λ/4 member arranged on an optical path between the half mirror and the reflection-type polarizing member, wherein an assembly formed by arranging three first laminate portions each including the second λ/4 member and at least one pressure-sensitive adhesive layer has an ISC value of 100 or less.

2. The lens unit according to the above-mentioned item 1 may include a second laminate portion including the reflection-type polarizing member.

3. In the lens unit according to the above-mentioned item 2, the first laminate portion and the second laminate portion may be arranged so as to be spaced apart from each other.

4. In the lens unit according to the above-mentioned item 2 or 3, the second laminate portion may include an absorption-type polarizing member arranged between the reflection-type polarizing member and the second lens portion.

5. In the lens unit according to any one of the above-mentioned items 2 to 4, the second laminate portion may include a third λ/4 member arranged between the reflection-type polarizing member and the second lens portion.

6. In the lens unit according to any one of the above-mentioned items 1 to 5, the first laminate portion may include a first protective member arranged on the front side of the second λ/4 member.

7. In the lens unit according to any one of the above-mentioned items 1 to 6, the number of the pressure-sensitive adhesive layers in the first laminate portion may be three or less.

8. In the lens unit according to any one of the above-mentioned items 1 to 7, a thickness of each of the pressure-sensitive adhesive layers in the first laminate portion may be 20 um or less.

9. In the lens unit according to any one of the above-mentioned items 1 to 8, a surface roughness Ra of each of the pressure-sensitive adhesive layers in the first laminate portion may be 20 nm or less.

10. In the lens unit according to any one of the above-mentioned items 1 to 9, each of the pressure-sensitive adhesive layers in the first laminate portion may be a single-layer body.

11. In the lens unit according to any one of the above-mentioned items 1 to 10, the first lens portion and the half mirror may be integrated with each other.

12. According to one embodiment of the present invention, there is provided a display body, including the lens unit of any one of the above-mentioned items 1 to 11.

13. According to one embodiment of the present invention, there is provided a display method, including the steps of: passing light representing an image, which has been emitted through a polarizing member and a first λ/4 member, through a half mirror and a first lens portion; passing the light, which has passed through the half mirror and the first lens portion, through a second λ/4 member; reflecting the light, which has passed through the second λ/4 member, toward the half mirror with a reflection-type polarizing member; enabling the light, which has been reflected by the reflection-type polarizing member and the half mirror, to penetrate through the reflection-type polarizing member with the second λ/4 member; and passing the light, which has penetrated through the reflection-type polarizing member, through a second lens portion, wherein an assembly formed by arranging three first laminate portions each including the second λ/4 member and at least one pressure-sensitive adhesive layer, has an ISC value of 100 or less.

Advantageous Effects of Invention

According to the lens unit of the embodiment of the present invention, the reduction in weight of the pair of VR goggles and the improvement in viewability thereof can be achieved.

Brief Description of Drawings

FIG. 1 is a schematic view for illustrating the schematic configuration of a display system according to one embodiment of the present invention.

FIG. 2 is a schematic sectional view for illustrating an example of details of a lens unit in the display system illustrated in FIG. 1.

FIG. 3 is a schematic perspective view for illustrating an example of a multilayer structure in a reflection-type polarizing film.

FIG. 4 is a view for describing a method of measuring an ISC value.

Description of Embodiments

Embodiments of the present invention are described below with reference to the drawings. However, the present invention is not limited to these embodiments. In addition, for clearer illustration, some widths, thicknesses, shapes, and

the like of respective portions may be schematically illustrated in the drawings in comparison to the embodiments. However, the widths, the thicknesses, the shapes, and the like are each merely an example, and do not limit the understanding of the present invention.

(Definitions of Terms and Symbols) The definitions of terms and symbols used herein are as described below.

(1) Refractive Indices (nx, ny, and nz) "nx" represents a refractive index in a direction in which an in-plane refractive index is maximum (that is, slow axis direction), "ny" represents a refractive index in a direction perpendicular to a slow axis in a plane (that is, fast axis direction), and "nz" represents a refractive index in a thickness direction.

(2) In-plane Retardation (Re) "Re(λ)" refers to an in-plane retardation measured at 23°C with light having a wavelength of λ nm. For example, "Re(550)" refers to an in-plane retardation measured at 23°C with light having a wavelength of 550 nm. The Re(λ) is determined from the equation "Re(λ)=(nx-ny)×d" when the thickness of a layer (film) is represented by "d" (nm).

(3) Thickness Direction Retardation (Rth) "Rth(λ)" refers to a thickness direction retardation measured at 23°C with light having a wavelength of λ nm. For example, "Rth(550)" refers to a thickness direction retardation measured at 23°C with light having a wavelength of 550 nm. The Rth(λ) is determined from the equation "Rth(λ)=(nx-nz)×d" when the thickness of a layer (film) is represented by "d" (nm).

(4) Nz Coefficient An Nz coefficient is determined from the equation "Nz=Rth/Re" .

(5) Angle When reference is made to an angle herein, the angle encompasses both angles in a clockwise direction and a counterclockwise direction with respect to a reference direction. Accordingly, for example, the term "45°" means ±45°.

FIG. **1** is a schematic view for illustrating the schematic configuration of a display system according to one embodiment of the present invention. The arrangement, shapes, and the like of the respective constituents of a display system **2** are schematically illustrated in FIG. **1.** The display system **2** includes: a display element **12;** a reflection-type polarizing member **14;** a first lens portion **16;** a half mirror **18;** a first retardation member **20;** a second retardation member **22;** and a second lens portion **24.** The reflection-type polarizing member **14** is arranged on a front side of the display element **12,** that is, on the display surface **12a** side thereof, and can reflect light emitted from the display element **12.** The first lens portion **16** is arranged on an optical path between the display element **12** and the reflection-type polarizing member **14,** and the half mirror **18** is arranged between the display element **12** and the first lens portion **16.** The first retardation member **20** is arranged on an optical path between the display element **12** and the half mirror **18,** and the second retardation member **22** is arranged on an optical path between the half mirror **18** and the reflection-type polarizing member **14.**

The half mirror and the constituents arranged on the front side thereof (in the illustrated example, the half mirror **18,** the first lens portion **16,** the second retardation member 22, the reflection-type polarizing member **14,** and the second lens portion **24)** are sometimes collectively referred to as "lens unit (lens unit **4).**"

The display element **12** is, for example, a liquid crystal display or an organic EL display, and has a display surface **12a** for displaying an image. The light to be emitted from the display surface **12a** passes through, for example, a polarizing member (typically, a polarizing film) that may be incorporated into the display element **12** to be emitted as first linearly polarized light.

The first retardation member **20** includes a first λ/4 member that can convert the first linearly polarized light, which has entered the first retardation member **20,** into first circularly polarized light. When the first retardation member is free of any member other than the first λ/4 member, the first retardation member may correspond to the first λ/4 member. The first retardation member **20** may be arranged integrally with the display element **12.**

The half mirror **18** transmits the light emitted from the display element **12,** and reflects the light reflected by the reflection-type polarizing member **14** toward the reflection-type polarizing member **14.** The half mirror **18** is arranged integrally with the first lens portion **16.**

The second retardation member **22** includes a second λ/4 member that can cause the light, which has been reflected by the reflection-type polarizing member **14** and the half mirror **18,** to penetrate through the reflection-type polarizing member **14.** When the second retardation member is free of any member other than the second λ/4 member, the second retardation member may correspond to the second λ/4 member. The second retardation member **22** may be arranged integrally with the first lens portion **16.**

The first circularly polarized light emitted from the first λ/4 member in the first retardation member **20** passes through the half mirror **18** and the first lens portion **16,** and is converted into second linearly polarized light by the second λ/4 member in the second retardation member **22.** The second linearly polarized light emitted from the second λ/4 member is

reflected toward the half mirror **18** without penetrating through the reflection-type polarizing member **14.** At this time, the polarization direction of the second linearly polarized light that has entered the reflection-type polarizing member **14** is the same direction as that of the reflection axis of the reflection-type polarizing member **14.** Accordingly, the second linearly polarized light that has entered the reflection-type polarizing member **14** is reflected by the reflection-type polarizing member **14.**

The second linearly polarized light reflected by the reflection-type polarizing member **14** is converted into second circularly polarized light by the second λ/4 member in the second retardation member **22,** and the second circularly polarized light emitted from the second λ/4 member passes through the first lens portion **16,** and is reflected by the half mirror **18.** The second circularly polarized light reflected by the half mirror **18** passes through the first lens portion **16,** and is converted into third linearly polarized light by the second λ/4 member in the second retardation member **22.** The third linearly polarized light penetrates through the reflection-type polarizing member **14.** At this time, the polarization direction of the third linearly polarized light that has entered the reflection-type polarizing member **14** is the same direction as that of the transmission axis of the reflection-type polarizing member **14.** Accordingly, the third linearly polarized light that has entered the reflection-type polarizing member **14** penetrates through the reflection-type polarizing member **14.**

The light that has penetrated through the reflection-type polarizing member **14** passes through the second lens portion **24** to enter an eye **26** of a user.

For example, the absorption axis of the polarizing member in the display element **12** and the reflection axis of the reflection-type polarizing member **14** may be arranged substantially parallel to each other, or may be arranged substantially perpendicular to each other. An angle formed by the absorption axis of the polarizing member in the display element **12** and the slow axis of the first λ/4 member in the first retardation member **20** is, for example, from 40° to 50°, and may be from 42° to 48°, or may be about 45°. An angle formed by the absorption axis of the polarizing member in the display element **12** and the slow axis of the second λ/4 member in the second retardation member **22** is, for example, from 40° to 50°, and may be from 42° to 48°, or may be about 45°.

The in-plane retardation Re(550) of the first λ/4 member is, for example, from 100 nm to 190 nm, and may be from 110 nm to 180 nm, may be from 130 nm to 160 nm, or may be from 135 nm to 155 nm. The first λ/4 member preferably shows such a reverse wavelength dispersion characteristic that its retardation value increases with an increase in wavelength of measurement light. The ratio "Re(450)/Re(550)" of the first λ/4 member is, for example, 0.75 or more and less than 1, and may be 0.8 or more and 0.95 or less.

The in-plane retardation Re(550) of the second λ/4 member is, for example, from 100 nm to 190 nm, and may be from 110 nm to 180 nm, may be from 130 nm to 160 nm, or may be from 135 nm to 155 nm. The second λ/4 member preferably shows such a reverse wavelength dispersion characteristic that its retardation value increases with an increase in wavelength of measurement light. The ratio "Re(450)/Re(550)" of the second λ/4 member is, for example, 0.75 or more and less than 1, and may be 0.8 or more and 0.95 or less.

In the lens unit **4,** a space may be formed between the first lens portion **16** and the second lens portion **24.** In this case, a member to be arranged between the first lens portion **16** and the second lens portion **24** is preferably arranged integrally with one of the first lens portion **16** or the second lens portion **24.** For example, the member to be arranged between the first lens portion **16** and the second lens portion **24** is preferably integrated with one of the first lens portion **16** or the second lens portion **24** via an adhesion layer. According to such form, for example, the handleability of each member can be excellent. The adhesion layer may be formed from an adhesive, or may be formed from a pressure-sensitive adhesive. Specifically, the adhesion layer may be an adhesive layer or a pressure-sensitive adhesive layer. The thickness of the adhesion layer is, for example, from 0.05 um to 30 μm.

FIG. **2** is a schematic sectional view for illustrating an example of details of a lens unit in the display system illustrated in FIG. **1.** Specifically, FIG. **2** is an illustration of a first lens portion, a second lens portion, and members to be arranged therebetween. The lens unit **4** includes the first lens portion **16,** a first laminate portion **100** arranged adjacent to the first lens portion **16,** the second lens portion **24,** and a second laminate portion **200** arranged adjacent to the second lens portion **24.** In the example illustrated in FIG. **2,** the first laminate portion **100** and the second laminate portion **200** are arranged so as to be spaced apart from each other. A half mirror may be arranged integrally with the first lens portion **16,** though the half mirror is not shown.

The first laminate portion **100** includes: the second retardation member **22;** and a pressure-sensitive adhesive layer **41** arranged between the first lens portion **16** and the second retardation member **22,** and is arranged integrally with the first lens portion **16** via the pressure-sensitive adhesive layer **41.** The first laminate portion **100** further includes a first protective member **31** arranged on the front side of the second retardation member **22.** The first protective member **31** is laminated on the second retardation member **22** via a pressure-sensitive adhesive layer **42.** The first protective member **31** may be positioned on the outermost surface of the first laminate portion **100.**

In the example illustrated in FIG. **2,** the second retardation member **22** includes a member (so-called positive C-plate) **22b** whose refractive index characteristic may show the relationship of nz>nx=ny in addition to a second λ/4 member **22a.** The second retardation member **22** has a laminated structure of the second λ/4 member **22a** and the positive C-plate **22b.** As illustrated in FIG. **2,** in the second retardation member **22,** it is preferred that the second λ/4 member **22a** be

positioned on the front side of the positive C-plate **22b.** The second λ/4 member **22a** and the positive C-plate **22b** are laminated via, for example, an adhesive layer (not shown).

The refractive index characteristic of the second λ/4 member preferably shows the relationship of nx>ny≥nz. The equation "ny=nz" as used herein encompasses not only a case in which the ny and the nz are completely equal to each other but also a case in which the ny and the nz are substantially equal to each other. Accordingly, the ny may be less than the nz to the extent that the effects of the present invention are not impaired. The Nz coefficient of the second λ/4 member is preferably from 0.9 to 3, more preferably from 0.9 to 2.5, still more preferably from 0.9 to 1.5, particularly preferably from 0.9 to 1.3.

The second λ/4 member is formed from any appropriate material that may satisfy the above-mentioned characteristics. The second λ/4 member may be, for example, a stretched film of a resin film or an alignment fixed layer of a liquid crystal compound.

A resin to be incorporated into the resin film is, for example, a polycarbonate-based resin, a polyester carbonate-based resin, a polyester-based resin, a polyvinyl acetal-based resin, a polyarylate-based resin, a cyclic olefin-based resin, a cellulose-based resin, a polyvinyl alcohol-based resin, a polyamide-based resin, a polyimide-based resin, a polyether-based resin, a polystyrene-based resin, or an acrylic resin. Those resins may be used alone or in combination thereof. A method for the combination is, for example, blending or copolymerization. When the second λ/4 member shows a reverse wavelength dispersion characteristic, a resin film containing a polycarbonate-based resin or a polyester carbonate-based resin (hereinafter sometimes simply referred to as "polycarbonate-based resin") may be suitably used.

Any appropriate polycarbonate-based resin may be used as the polycarbonate-based resin. For example, the polycarbonate-based resin includes a structural unit derived from a fluorene-based dihydroxy compound, a structural unit derived from an isosorbide-based dihydroxy compound, and a structural unit derived from at least one dihydroxy compound selected from the group consisting of: an alicyclic diol; an alicyclic dimethanol; di-, tri-, or polyethylene glycol; and an alkylene glycol or a spiroglycol. The polycarbonate-based resin preferably includes a structural unit derived from a fluorene-based dihydroxy compound, a structural unit derived from an isosorbide-based dihydroxy compound, and a structural unit derived from an alicyclic dimethanol and/or a structural unit derived from di-, tri-, or polyethylene glycol, and more preferably includes a structural unit derived from a fluorene-based dihydroxy compound, a structural unit derived from an isosorbide-based dihydroxy compound, and a structural unit derived from di-, tri-, or polyethylene glycol. The polycarbonate-based resin may include a structural unit derived from any other dihydroxy compound as required. The Details of e polycarbonate-based resin that may be suitably used in the second λ/4 member and a method of forming the second λ/4 member are described in, for example, JP 2014-10291 A, JP 2014-26266 A, JP 2015-212816 A, JP 2015-212817 A, and JP 2015-212818 A, the descriptions of which are incorporated herein by reference.

The thickness of the second λ/4 member including the stretched film of the resin film is, for example, from 10 um to 100 μm, preferably from 10 um to 70 μm, more preferably from 20 um to 60 μm.

The alignment fixed layer of the liquid crystal compound is such a layer that the liquid crystal compound is aligned in a predetermined direction in the layer, and its alignment state is fixed. The term "alignment fixed layer" is a concept encompassing an alignment cured layer obtained by curing a liquid crystal monomer as described later. In the second λ/4 member, the molecules of a rod-shaped liquid crystal compound are typically aligned under the state of being lined up in the slow axis direction of the second λ/4 member (homogeneous alignment). Examples of the rod-shaped liquid crystal compound include a liquid crystal polymer and a liquid crystal monomer. The liquid crystal compound is preferably polymerizable. When the liquid crystal compound is polymerizable, the alignment state of the liquid crystal compound can be fixed by aligning the liquid crystal compound and then polymerizing the compound.

The alignment fixed layer of the liquid crystal compound (liquid crystal alignment fixed layer) may be formed by: subjecting the surface of a predetermined substrate to alignment treatment; applying an application liquid containing a liquid crystal compound to the surface; aligning the liquid crystal compound in a direction corresponding to the alignment treatment; and fixing the alignment state. Any appropriate alignment treatment may be adopted as the alignment treatment. Specific examples thereof include mechanical alignment treatment, physical alignment treatment, and chemical alignment treatment. Specific examples of the mechanical alignment treatment include rubbing treatment and stretching treatment. Specific examples of the physical alignment treatment include magnetic field alignment treatment and electric field alignment treatment. Specific examples of the chemical alignment treatment include an oblique deposition method and photoalignment treatment. Any appropriate conditions may be adopted as treatment conditions for the various alignment treatments in accordance with purposes.

The alignment of the liquid crystal compound is performed through treatment at a temperature at which the liquid crystal compound shows a liquid crystal phase depending on the kind of the liquid crystal compound. When the treatment at such temperature is performed, the liquid crystal compound adopts a liquid crystal state, and the liquid crystal compound is aligned in accordance with the alignment treatment direction of the surface of the substrate.

In one embodiment, the fixation of the alignment state is performed by cooling the liquid crystal compound aligned as described above. When the liquid crystal compound is polymerizable or cross-linkable, the fixation of the alignment state is performed by subjecting the liquid crystal compound aligned as described above to polymerization treatment or

cross-linking treatment.

Any appropriate liquid crystal polymer and/or liquid crystal monomer is used as the liquid crystal compound. The liquid crystal polymers and the liquid crystal monomers may each be used alone or in combination thereof. Specific examples of the liquid crystal compound and a method of producing the liquid crystal alignment fixed layer are described in, for example, JP 2006-163343 A, JP 2006-178389 A, and WO 2018/123551 A1, the descriptions of which are incorporated herein by reference.

The thickness of the second λ/4 member including the liquid crystal alignment fixed layer is, for example, from 1 um to 10 μm, preferably from 1 um to 8 μm, more preferably from 1 um to 6 μm, still more preferably from 1 um to 4 μm.

The thickness direction retardation Rth(550) of the positive C-plate is preferably from -50 nm to -300 nm, more preferably from -70 nm to -250 nm, still more preferably from - 90 nm to -200 nm, particularly preferably from -100 nm to -180 nm. The equation "nx=ny" as used herein encompasses not only a case in which the nx and the ny are strictly equal to each other but also a case in which the nx and the ny are substantially equal to each other. The in-plane retardation Re(550) of the positive C-plate is, for example, less than 10 nm.

The positive C-plate may be formed from any appropriate material. However, the positive C-plate preferably includes a film containing a liquid crystal material fixed in homeotropic alignment. The liquid crystal material (liquid crystal compound) that can be homeotropically aligned may be a liquid crystal monomer or a liquid crystal polymer. Such liquid crystal compound and a method of forming the positive C-plate are specifically, for example, a liquid crystal compound and a method of forming the retardation layer described in paragraphs to [0028] of JP 2002-333642 A. In this case, the thickness of the positive C-plate is preferably from 0.5 um to 5 μm.

The first protective member typically includes a substrate. The thickness of the substrate is preferably from 5 um to 80 μm, more preferably from 10 um to 50 μm, still more preferably from 15 um to 40 um. The substrate may include any appropriate film. Examples of a material serving as a main component for the film for forming the substrate include a cellulose-based resin such as triacetyl cellulose (TAC), a polyester-based resin, a polyvinyl alcohol-based resin, a polycarbonate-based resin, a polyamide-based resin, a polyimide-based resin, a polyether sulfone-based resin, a polysulfone-based resin, a polystyrene-based resin, and a cycloolefin-based resin such as polynorbornene, a polyolefin-based resin, a (meth)acrylic resin, and an acetate-based resin. The term "(meth)acrylic" as used herein refers to acrylic and/or methacrylic. In one embodiment, the substrate preferably includes a (meth)acrylic resin. When the (meth) acrylic resin is adopted, a substrate excellent in smoothness can be formed by extrusion molding. In addition, a protective member excellent in smoothness can be obtained.

The first protective member preferably includes the substrate and a surface-treated layer formed on the substrate. The first protective member including the surface-treated layer may be arranged so that the surface-treated layer may be positioned on the front side. Specifically, the surface-treated layer may be positioned on the outermost surface of the first laminate portion. The surface-treated layer may have any appropriate function. The surface-treated layer preferably has an antireflection function from the viewpoint of, for example, improving the viewability. The thickness of the surface-treated layer is preferably from 0.5 um to 10 μm, more preferably from 1 um to 7 μm, still more preferably from 2 um to 5 μm.

The second laminate portion **200** includes: the reflection-type polarizing member **14;** and a pressure-sensitive adhesive layer arranged between the reflection-type polarizing member **14** and the second lens portion **24.** The second laminate portion **200** further includes an absorption-type polarizing member **28** arranged between the reflection-type polarizing member **14** and the second lens portion **24** from the viewpoint of, for example, improving the viewability. The absorption-type polarizing member **28** is laminated on the front side of the reflection-type polarizing member **14** via a pressure-sensitive adhesive layer **44.** The reflection axis of the reflection-type polarizing member **14** and the absorption axis of the absorption-type polarizing member **28** may be arranged substantially parallel to each other, and the transmission axis of the reflection-type polarizing member **14** and the transmission axis of the absorption-type polarizing member **28** may be arranged substantially parallel to each other. The reflection-type polarizing member **14** and the absorption-type polarizing member **28** are fixed to each other through lamination of the members via the pressure-sensitive adhesive layer, and hence a shift in the axial arrangement of the reflection axis of the member **14** and the absorption axis of the member **28** (the transmission axis of the member **14** and the transmission axis of the member **28)** can be prevented. In addition, an adverse effect due to an air layer that may be formed between the reflection-type polarizing member **14** and the absorption-type polarizing member **28** can be suppressed.

The second laminate portion **200** further includes a second protective member **32** arranged on a back side of the reflection-type polarizing member **14.** The second protective member **32** is laminated on the reflection-type polarizing member **14** via a pressure-sensitive adhesive layer 43. The second protective member **32** may be positioned on the outermost surface of the second laminate portion **200.** The second protective member may include a substrate as in the first protective member. In addition, the second protective member preferably includes the substrate and a surface-treated layer to be formed on the substrate. In this case, the surface-treated layer may be positioned on the outermost surface of the second laminate portion. For the details of the substrate and the surface-treated layer, the same descriptions as those in the first protective member may be applied.

As illustrated in FIG. **2,** the second laminate portion **200** may further include a third retardation member **30** arranged between the absorption-type polarizing member **28** and the second lens portion **24.** The third retardation member **30** is laminated on the absorption-type polarizing member **28** via a pressure-sensitive adhesive layer **45.** In addition, the third retardation member **30** is laminated on the second lens portion **24** via a pressure-sensitive adhesive layer **46,** and the second laminate portion **200** is arranged integrally with the second lens portion **24.** The third retardation member **30** includes, for example, a third λ/4 member. An angle formed by the absorption axis of the absorption-type polarizing member **28** and the slow axis of the third λ/4 member in the third retardation member **30** is, for example, from 40° to 50°, may be from 42° to 48°, or may be about 45°. When such member is arranged, for example, the reflection of ambient light from a second lens portion **24** side can be prevented. When the third retardation member is free of any member other than the third λ/4 member, the third retardation member may correspond to the third λ/4 member.

The above-mentioned reflection-type polarizing member can transmit polarized light (typically, linearly polarized light) parallel to its transmission axis while maintaining the polarization state of the light, and can reflect light in any other polarization state. The reflection-type polarizing member typically includes a film having a multilayer structure (sometimes referred to as "reflection-type polarizing film"). In this case, the thickness of the reflection-type polarizing member is, for example, from 10 um to 150 μm, preferably from 20 um to 100 μm, more preferably from 30 um to 60 μm.

FIG. 3 is a schematic perspective view for illustrating an example of the multilayer structure in the reflection-type polarizing film. A multilayer structure **14a** alternately includes a layer A having birefringence and a layer B substantially free of birefringence. The total number of the layers for forming the multilayer structure may be from 50 to 1,000. For example, the refractive index nx of the A layer in an x-axis direction is larger than the refractive index ny thereof in a y-axis direction, the refractive index nx of the B layer in the x-axis direction and the refractive index ny thereof in the y-axis direction are substantially identical to each other, and a difference in refractive index between the A layer and the B layer is large in the x-axis direction, and is substantially zero in the y-axis direction. As a result, the x-axis direction may serve as a reflection axis, and the y-axis direction may serve as a transmission axis. The difference in refractive index between the A layer and the B layer in the x-axis direction is preferably from 0.2 to 0.3.

The above-mentioned A layer typically includes a material that expresses birefringence by being stretched. Examples of such material include a naphthalene dicarboxylic acid polyester (e.g., polyethylene naphthalate), polycarbonate, and an acrylic resin (e.g., polymethyl methacrylate). The above-mentioned B layer typically includes a material that is substantially free from expressing birefringence even when stretched. Such material is, for example, a copolyester of naphthalene dicarboxylic acid and terephthalic acid. The above-mentioned multilayer structure may be formed by combining coextrusion and stretching. For example, the material for forming the A layer and the material for forming the B layer are extruded, and are then multilayered (with, for example, a multiplier). Next, the resultant multilayer laminate is stretched. The x-axis direction in the illustrated example may correspond to the stretching direction.

A commercial product of the reflection-type polarizing film is, for example, a product available under the product name "DBEF" or "APF" from 3M Company, or a product available under the product name "APCF" from Nitto Denko Corporation.

The cross transmittance (Tc) of the reflection-type polarizing member (reflection-type polarizing film) may be, for example, from 0.01% to 3%. The single layer transmittance (Ts) of the reflection-type polarizing member (reflection-type polarizing film) is, for example, from 43% to 49%, preferably from 45% to 47%. The polarization degree (P) of the reflection-type polarizing member (reflection-type polarizing film) may be, for example, from 92% to 99.99%.

The cross transmittance, the single layer transmittance, and the polarization degree described above may each be measured with, for example, a UV-visible spectrophotometer. The polarization degree P may be determined as follows: the single layer transmittance Ts, the parallel transmittance Tp, and the cross transmittance Tc are measured with the UV-visible spectrophotometer; and the degree is determined from the Tp and Tc thus obtained by using the following equation. The Ts, the Tp, and the Tc are each a Y value measured with the two-degree field of view (C light source) of JIS Z 8701 and subjected to visibility correction.

$$\text{Polarization degree P }(\%)=\{(Tp-Tc)/(Tp+Tc)\}^{1/2}\times 100$$

The above-mentioned absorption-type polarizing member may typically include a resin film containing a dichroic substance (sometimes referred to as "absorption-type polarizer"). The thickness of the absorption-type polarizer is, for example, 1 um or more and 20 um or less, and may be 2 um or more and 15 um or less, may be 12 um or less, may be 10 um or less, may be 8 um or less, or may be 5 um or less.

The above-mentioned absorption-type polarizer may be produced from a single-layer resin film, or may be produced by using a laminate of two or more layers.

When the absorption-type polarizer is produced from the single-layer resin film, the absorption-type polarizer may be obtained by, for example, subjecting a hydrophilic polymer film, such as a polyvinyl alcohol (PVA)-based film, a partially formalized PVA-based film, or an ethylene-vinyl acetate copolymer-based partially saponified film, to dyeing treatment with a dichroic substance, such as iodine or a dichroic dye, stretching treatment, or the like. Of such polarizers,

an absorption-type polarizer obtained by dyeing a PVA-based film with iodine and uniaxially stretching the dyed film is preferred.

The above-mentioned dyeing with iodine is performed by, for example, immersing the PVA-based film in an aqueous solution of iodine. The stretching ratio of the above-mentioned uniaxial stretching is preferably from 3 times to 7 times. The stretching may be performed after the dyeing treatment, or may be performed while the dyeing is performed. Alternatively, the dyeing may be performed after the stretching. The PVA-based film is subjected to swelling treatment, cross-linking treatment, washing treatment, drying treatment, or the like as required.

When the absorption-type polarizer is produced by using the above-mentioned laminate of two or more layers, the laminate is, for example, a laminate of a resin substrate and a PVA-based resin layer (PVA-based resin film) laminated on the resin substrate or a laminate of a resin substrate and a PVA-based resin layer formed on the resin substrate through application. The absorption-type polarizer obtained by using the laminate of the resin substrate and the PVA-based resin layer formed on the resin substrate through application may be produced, for example, by: applying a PVA-based resin solution to the resin substrate; drying the solution to form the PVA-based resin layer on the resin substrate, to thereby provide the laminate of the resin substrate and the PVA-based resin layer; and stretching and dyeing the laminate to turn the PVA-based resin layer into the absorption-type polarizer. In this embodiment, a polyvinyl alcohol-based resin layer containing a halide and a polyvinyl alcohol-based resin is preferably formed on one side of the resin substrate. The stretching typically includes stretching the laminate under a state in which the laminate is immersed in an aqueous solution of boric acid. Further, the stretching may further include in-air stretching of the laminate at high temperature (e.g., 95°C or more) before the stretching in the aqueous solution of boric acid as required. In addition, in this embodiment, the laminate is preferably subjected to drying shrinkage treatment, which includes heating the laminate, while conveying the laminate in its lengthwise direction, to shrink the laminate by 2% or more in its widthwise direction. The production method of this embodiment typically includes subjecting the laminate to in-air auxiliary stretching treatment, dyeing treatment, underwater stretching treatment, and drying shrinkage treatment in the stated order. When the auxiliary stretching is introduced, even in the case where PVA is applied onto a thermoplastic resin, the crystallinity of PVA can be improved, and hence high optical characteristics can be achieved. In addition, when the alignment property of PVA is improved in advance simultaneously with the crystallinity improvement, problems, such as a reduction in alignment property of PVA and the dissolution thereof, can be prevented at the time of the immersion of the laminate in water in the subsequent dyeing step or stretching step, and hence high optical characteristics can be achieved. Further, in the case where the PVA-based resin layer is immersed in a liquid, the disturbance of the alignment of the molecules of polyvinyl alcohol and reductions in alignment properties thereof can be suppressed as compared to those in the case where the PVA-based resin layer is free of any halide. Thus, the optical characteristics of the absorption-type polarizer to be obtained through treatment steps performed by immersing the laminate in a liquid, such as the dyeing treatment and the underwater stretching treatment, can be improved. Further, the optical characteristics can be improved by shrinking the laminate in its widthwise direction through the drying shrinkage treatment. The resultant laminate of the resin substrate and the absorption-type polarizer may be used as it is (that is, the resin substrate may be used as a protective layer for the absorption-type polarizer), or may be used by laminating any appropriate protective layer in accordance with purposes on the peeled surface on which the resin substrate has been peeled from the laminate of the resin substrate and the absorption-type polarizer, or on a surface on the side opposite to the peeled surface. The details of such method of producing the absorption-type polarizer are described in, for example, JP 2012-73580 A and JP 6470455 B1, the descriptions of which are incorporated herein by reference in their entirety.

The cross transmittance (Tc) of the absorption-type polarizing member (absorption-type polarizer) is preferably 0.5% or less, more preferably 0.1% or less, still more preferably 0.05% or less. The single layer transmittance (Ts) of the absorption-type polarizing member (absorption-type polarizer) is, for example, from 41.0% to 45.0%, preferably 42.0% or more. The polarization degree (P) of the absorption-type polarizing member (absorption-type polarizer) is, for example, from 99.0% to 99.997%, preferably 99.9% or more.

The in-plane retardation Re(550) of the third λ/4 member is, for example, from 100 nm to 190 nm, and may be from 110 nm to 180 nm, may be from 130 nm to 160 nm, or may be from 135 nm to 155 nm. The third λ/4 member preferably shows such a reverse wavelength dispersion characteristic that its retardation value increases with an increase in wavelength of measurement light. The ratio "Re(450)/Re(550)" of the third λ/4 member is, for example, 0.75 or more and less than 1, and may be 0.8 or more and 0.95 or less. The refractive index characteristic of the third λ/4 member preferably shows the relationship of $nx>ny\geq nz$. The Nz coefficient of the third λ/4 member is preferably from 0.9 to 3, more preferably from 0.9 to 2.5, still more preferably from 0.9 to 1.5, particularly preferably from 0.9 to 1.3.

The third λ/4 member is formed from any appropriate material that may satisfy the above-mentioned characteristics. The third λ/4 member may be, for example, a stretched film of a resin film or an alignment fixed layer of a liquid crystal compound. The same description as that of the above-mentioned second λ/4 member may be applied to the third λ/4 member including the stretched film of the resin film or the alignment fixed layer of the liquid crystal compound. The second λ/4 member and the third λ/4 member may be members having the same configuration (e.g., a formation material, a thickness, or an optical characteristic), or may be members having different configurations.

In the lens unit **4,** the ISC value of an assembly formed by arranging three first laminate portions from a member positioned on the front side of the first lens portion **16** to a member positioned on the back side of the reflection-type polarizing member **14** is 100 or less, preferably 90 or less, more preferably 80 or less, still more preferably 70 or less. When such ISC value is satisfied, a display system extremely excellent in viewability can be achieved. Specifically, when such ISC value is satisfied, the occurrence of diffused light in the lens unit is suppressed, and hence an image can be suppressed from becoming unclear. The ISC value may serve as an indicator of smoothness or unevenness. In addition, the ISC value of the assembly formed by arranging the three first laminate portions may serve as an indicator of the viewability of the entire display system. Light may pass through the first laminate portion three times in the display system, and hence the first laminate portion may be largely involved in the viewability of the display system. In the example illustrated in FIG. 2, for example, the first laminate portion **100** includes a member positioned on the back side of the space formed between the first lens portion **16** and the reflection-type polarizing member **14** from the viewpoint of the convenience of an evaluation. Specifically, the first laminate portion **100** includes the pressure-sensitive adhesive layer **41,** the second retardation member **22** including the second λ/4 member **22a,** the pressure-sensitive adhesive layer **42,** and the first protective member **31.** Substantially, the lower limit of the ISC value of the assembly formed by arranging the three first laminate portions is about 5.

In the example illustrated in FIG. **2,** when the respective members to be arranged between the first lens portion **16** and the second lens portion **24** are arranged integrally with the first lens portion **16** or the second lens portion **24,** six pressure-sensitive adhesive layers, that is, the pressure-sensitive adhesive layers **41** to **46** are used. In the example illustrated in FIG. **2,** the number of the pressure-sensitive adhesive layers in the first laminate portion **100** is two. The number of the pressure-sensitive adhesive layers in the first laminate portion **100** varies depending on, for example, the number of members to be arranged between the first lens portion **16** and the reflection-type polarizing member **14.** The number of the pressure-sensitive adhesive layers in the first laminate portion is preferably three or less, more preferably two or less. With such configuration, the above-mentioned ISC value can be satisfactorily achieved in the first laminate portion.

The thickness of each of the pressure-sensitive adhesive layers to be used for the lamination of the respective members may be set to any appropriate thickness. The thickness of each of the pressure-sensitive adhesive layers to be used for the lamination of the respective members is preferably 20 um or less, and may be 15 um or less, may be 10 um or less, or may be 7 um or less. With such thickness, the degree of unevenness of the surface of the pressure-sensitive adhesive layer can be suppressed, and the above-mentioned ISC value can be satisfactorily achieved in the first laminate portion. Meanwhile, the thickness of the pressure-sensitive adhesive layer is, for example, 3 um or more.

The surface roughness Ra of each of the pressure-sensitive adhesive layers to be used for the lamination of the respective members is preferably 20 nm or less, more preferably 15 nm or less. With such surface roughness Ra, the above-mentioned ISC value can be satisfactorily achieved in the first laminate portion.

The pressure-sensitive adhesive layer may include any appropriate pressure-sensitive adhesive. Specific examples thereof include an acrylic pressure-sensitive adhesive, a rubber-based pressure-sensitive adhesive, a silicone-based pressure-sensitive adhesive, a polyester-based pressure-sensitive adhesive, a urethane-based pressure-sensitive adhesive, an epoxy-based pressure-sensitive adhesive, and a polyether-based pressure-sensitive adhesive. A pressure-sensitive adhesive having desired characteristics in accordance with purposes may be prepared by adjusting, for example, the kinds, number, combination, and blending ratios of monomers for forming the base resin of the pressure-sensitive adhesive, the blending amount of a cross-linking agent, a reaction temperature, and a reaction time. The base resins of the pressure-sensitive adhesive may be used alone or in combination thereof. An acrylic resin is preferably used as the base resin. Specifically, the pressure-sensitive adhesive layer preferably includes an acrylic pressure-sensitive adhesive.

For example, the pressure-sensitive adhesive layer may be formed by applying a pressure-sensitive adhesive composition containing a base resin, an additive such as a cross-linking agent, and a solvent, and drying the composition. The pressure-sensitive adhesive composition may be directly applied to an adherend, or may be applied to a base such as a substrate film that has been separately prepared. The drying is typically performed by heating.

The surface roughness Ra may be satisfied by, for example, adjusting the thickness of the coating film of the pressure-sensitive adhesive composition. When the thickness is too large, a liquid flow due to a temperature difference may occur in the coating film through the heating, and hence a pressure-sensitive adhesive layer having a large degree of unevenness on a surface thereof may be formed.

In addition, the surface roughness Ra may be satisfied by, for example, controlling conditions for drying the coating film of the pressure-sensitive adhesive composition. Specifically, the surface roughness Ra may be satisfied by adjusting the airflow volume and airflow rate of air to be applied to the coating film at the time of the drying. When the airflow volume and airflow rate of the air to be applied to the coating film are too large, a wave may occur on the coating film, and hence a pressure-sensitive adhesive layer having a large degree of unevenness on a surface thereof may be formed. In one embodiment, the coating film is preferably dried under the temperature environment of from 65°C to 110°C while the airflow rate is adjusted within the range of preferably from 2 m/min to 15 m/min, more preferably from 2 m/min to 8 m/min.

For example, it is preferred that the adjustment be made to such temperature and airflow rate in the vicinity of the inlet of an oven for performing the drying after the application. Specifically, the adjustment may be made to such temperature and airflow rate from the inlet of the oven toward the center portion of the oven.

It is preferred that the pressure-sensitive adhesive layers to be used for the lamination of the respective members each include a single-layer body. For example, it is preferred that each of the pressure-sensitive adhesive layers be free of any multilayer structure formed by applying the pressure-sensitive adhesive composition twice or more. When the pressure-sensitive adhesive layer includes a single-layer body, for example, the above-mentioned surface roughness Ra can be satisfied.

## Examples

The present invention is specifically described below by way of Examples. However, the present invention is not limited to these Examples. A thickness, a surface roughness Ra, and a retardation value are values measured by the following measurement methods.

<Thickness>

A thickness of 10 um or less was measured with a scanning electron microscope (manufactured by JEOL Ltd., product name: "JSM-7100F"). A thickness of more than 10 um was measured with a digital micrometer (manufactured by Anritsu Corporation, product name: "KC-351C").

<Surface Roughness Ra>

An arithmetic average surface roughness Ra (um) was measured in conformity with JIS B 0601 (1994 Edition).

A pressure-sensitive adhesive layer serving as a measurement object was bonded to a glass plate (manufactured by Matsunami Glass Ind., Ltd., MICRO SLIDE GLASS, product number: S, thickness: 1.3 mm, 45 mm×50 mm) to produce a measurement sample. The bonding of the pressure-sensitive adhesive layer was performed by transferring the pressure-sensitive adhesive layer formed on a substrate film from the substrate film to the glass plate. The obtained measurement sample was measured with a scanning white-light interferometer (manufactured by Zygo Corporation, product name: "NewView 7300"). Specifically, the measurement sample was placed on a measurement table with a vibration isolation table to generate interference fringes with single white LED lighting. The sample was scanned with an interference objective lens (magnification: 2.5) having a reference surface in a Z-direction (thickness direction). Thus, the smoothness (surface smoothness) of the pressure-sensitive adhesive layer on its outermost surface in the range of a field of view of 2 mm□ was selectively acquired. The arithmetic average surface roughness Ra was calculated based on the measurement.

<Retardation Value>

Retardation values at respective wavelengths at 23°C were measured with a Mueller matrix polarimeter (manufactured by Axometrics, Inc., product name: "AxoScan").

[Example 1]

(Formation of Pressure-sensitive Adhesive Layer)

A monomer mixture containing 92 parts by weight of butyl acrylate, 2.9 parts by weight of acrylic acid, 0.1 part by weight of 2-hydroxyethyl acrylate, and 5 parts by weight of N-acryloylmorpholine was loaded into a four-necked flask including a stirring blade, a temperature gauge, a nitrogen gas introduction tube, and a condenser. Further, 0.1 part by weight of 2,2'-azobisisobutyronitrile serving as a polymerization initiator was loaded into 100 parts by weight of the monomer mixture together with 200 parts by weight of ethyl acetate, and the inside of the flask was purged with nitrogen by introducing a nitrogen gas under gentle stirring. After that, a polymerization reaction was performed for 8 hours while a liquid temperature in the flask was kept at about 55°C. Thus, a solution of an acrylic polymer having a weight-average molecular weight (Mw) of 1,780,000 was prepared.

A coating film on a substrate film obtained by applying the acrylic polymer solution to the substrate film was dried in an oven. Thus, a pressure-sensitive adhesive layer having a thickness of 5 um and a surface roughness Ra of 12 nm was formed. The drying was performed while an airflow rate in the oven from the inlet of the oven to the center portion of the oven was adjusted within the range of 15 m/min or less. The airflow rate was measured with an anemometer arranged in the oven.

(Production of λ/4 Member)

Polymerization was performed with a batch polymerization apparatus formed of two vertical reactors each including a stirring blade and a reflux condenser controlled to 100°C. 29.60 Parts by weight (0.046 mol) of bis[9-(2-phenoxycarbonylethyl)fluoren-9-yl]methane, 29.21 parts by weight (0.200 mol) of isosorbide (ISB), 42.28 parts by weight (0.139 mol) of spiroglycol (SPG), 63.77 parts by weight (0.298 mol) of diphenyl carbonate (DPC), and $1.19\times10^{-2}$ part by weight ($6.78\times10^{-5}$ mol) of calcium acetate monohydrate serving as a catalyst were loaded into the batch polymerization apparatus. After the inside of the reactor had been purged with nitrogen under reduced pressure, the inside was warmed with a heat medium, and stirring was started at the time point when the internal temperature became 100°C. 40 Minutes after the start of the temperature increase, the internal temperature was caused to reach 220°C, and such control that the temperature was held was performed. At the same time, a pressure reduction was started, and a pressure in the reactor was set to 13.3 kPa in 90 minutes after the temperature had reached 220°C. Phenol vapor produced as a by-product along with a polymerization reaction was introduced into the reflux condenser at 100°C, a monomer component present in a trace amount in the phenol vapor was returned to the reactor, and the phenol vapor that did not condense was introduced into a condenser at 45°C and recovered. Nitrogen was introduced into the first reactor to return the pressure therein to the atmospheric pressure once, and then an oligomerized reaction liquid in the first reactor was transferred to the second reactor. Next, a temperature increase and a pressure reduction in the second reactor were started, and the internal temperature and the pressure were set to 240°C and 0.2 kPa, respectively in 50 minutes. After that, the polymerization was advanced until predetermined stirring power was obtained. At the time point when the predetermined power was achieved, nitrogen was introduced into the reactor to return the pressure, and the produced polyester carbonate-based resin was extruded into water, followed by the cutting of a strand. Thus, a pellet was obtained.

The resultant polyester carbonate-based resin (pellet) was dried in a vacuum at 80°C for 5 hours, and then an elongate resin film having a thickness of 135 um was produced from the resin with a film-forming apparatus including a single-screw extruder (manufactured by Toshiba Machine Co., Ltd., cylinder set temperature: 250°C), a T-die (width: 200 mm, set temperature: 250°C), a chill roll (set temperature: from 120°C to 130°C), and a winding machine. The resultant elongate resin film was stretched in its widthwise direction at a stretching temperature of 143°C and a stretching ratio of 2.8 times to provide a stretched film having a thickness of 47 um. The resultant stretched film had an Re(550) of 143 nm, a ratio "Re(450)/Re(550)" of 0.86, and an Nz coefficient of 1.2.

(Production of Positive C-plate)

20 Parts by weight of a side chain-type liquid crystal polymer represented by the following chemical formula (1) (numbers 65 and 35 in the formula each represent the mole percent of a monomer unit, and the polymer is represented in a block polymer form for convenience: weight-average molecular weight: 5,000), 80 parts by weight of a polymerizable liquid crystal showing a nematic liquid crystal phase (manufactured by BASF SE: product name: Paliocolor LC242), and 5 parts by weight of a photopolymerization initiator (manufactured by Ciba Specialty Chemicals: product name: IRGACURE 907) were dissolved in 200 parts by weight of cyclopentanone to prepare a liquid crystal application liquid. Then, the application liquid was applied to a PET substrate subjected to vertical alignment treatment with a bar coater, and was then dried by heating at 80°C for 4 minutes so that the liquid crystal was aligned. UV light was applied to the liquid crystal layer to cure the liquid crystal layer. Thus, a positive C-plate having a thickness of 4 um and a Rth(550) of -100 nm was formed on the substrate.

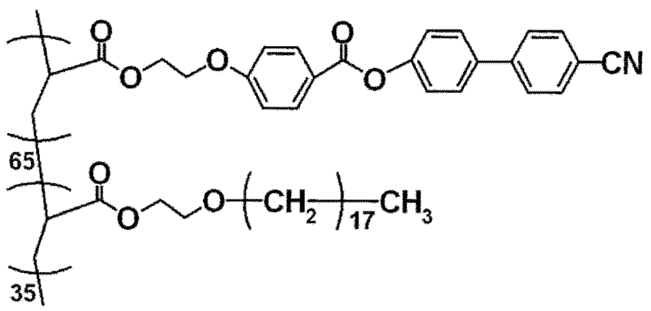

・・・(1)

(Production of Protective Member)

A material for forming a hard coat layer to be described below was applied to an acrylic film having a lactone ring structure (thickness: 40 um). The resultant was heated at 90°C for 1 minute. The applied layer after the heating was irradiated with UV light at an integrated light quantity of 300 mJ/$cm^2$ with a high-pressure mercury lamp so that the applied

layer was cured. Thus, an acrylic film (thickness: 44 um) having a hard coat layer having a thickness of 4 um formed thereon was produced.

Next, an application liquid A for forming an antireflection layer to be described below was applied onto the above-mentioned hard coat layer with a wire bar. The applied application liquid was dried by heating at 80°C for 1 minute to form a coating film. The coating film after the drying was irradiated with UV light at an integrated light quantity of 300 $mJ/cm^2$ with a high-pressure mercury lamp so that the coating film was cured. Thus, an antireflection layer A having a thickness of 140 nm was formed.

Subsequently, an application liquid B for forming an antireflection layer to be described below was applied onto the antireflection layer A with a wire bar. The applied application liquid was dried by heating at 80°C for 1 minute to form a coating film. The coating film after the drying was irradiated with UV light at an integrated light quantity of 300 $mJ/cm^2$ with a high-pressure mercury lamp so that the coating film was cured. Thus, an antireflection layer B having a thickness of 105 nm was formed.

Thus, a protective member (thickness: 44 um) was obtained.

(Material for forming Hard Coat Layer)

50 Parts of a urethane acrylic oligomer (manufactured by Shin-Nakamura Chemical Co., Ltd., "NK Oligo UA-53H"), 30 parts of a polyfunctional acrylate containing pentaerythritol triacrylate as a main component (manufactured by Osaka Organic Chemical Industry Ltd., product name: "Viscoat #300"), 20 parts of 4-hydroxybutyl acrylate (manufactured by Osaka Organic Chemical Industry Ltd.), 1 part of a leveling agent (manufactured by DIC Corporation, "GRANDIC PC4100"), and 3 parts of a photopolymerization initiator (manufactured by Ciba Japan K.K., "IRGACURE 907") were mixed. The mixture was diluted with methyl isobutyl ketone so as to have a solid content concentration of 50%. Thus, a material for forming a hard coat layer was prepared.

(Application Liquid A for forming Antireflection Layer)

100 Parts by weight of a polyfunctional acrylate (manufactured by Arakawa Chemical Industries, Ltd., product name: "OPSTAR KZ6728", solid content: 20 wt%), 3 parts by weight of a leveling agent (manufactured by DIC Corporation, "GRANDIC PC4100"), and 3 parts by weight of a photopolymerization initiator (manufactured by BASF SE, product name: "OMNIRAD 907", solid content: 100 wt%) were mixed. Butyl acetate was used as a diluting solvent to adjust the solid content of the mixture to 12 wt%, followed by stirring. Thus, the application liquid A for forming an antireflection layer was prepared.

(Application Liquid B for forming Antireflection Layer)

100 Parts by weight of a polyfunctional acrylate containing pentaerythritol triacrylate as a main component (manufactured by Osaka Organic Chemical Industry Ltd., product name: "Viscoat #300", solid content: 100 wt%), 150 parts by weight of hollow nano-silica particles (manufactured by JGC Catalysts and Chemicals Ltd., product name: "THRULYA 5320", solid content: 20 wt%, weight-average particle diameter: 75 nm), 50 parts by weight of solid nano-silica particles (manufactured by Nissan Chemical Corporation, product name: "MEK-2140Z-AC", solid content: 30 wt%, weight-average particle diameter: 10 nm), 12 parts by weight of a fluorine element-containing additive (manufactured by Shin-Etsu Chemical Co., Ltd., product name: "KY-1203", solid content: 20 wt%), and 3 parts by weight of a photopolymerization initiator (manufactured by BASF SE, product name: "OMNIRAD 907", solid content: 100 wt%) were mixed. A mixed solvent obtained by mixing tertiary butyl alcohol (TBA), methyl isobutyl ketone (MIBK), and propylene glycol monomethyl ether acetate (PMA) at a weight ratio of 60:25:15 was added as a diluting solvent to the mixture so that an entire solid content became 4 wt%, followed by stirring. Thus, the application liquid B for forming an antireflection layer was prepared.

(First Laminate Portion)

A retardation member was obtained by bonding the positive C-plate to the $\lambda/4$ member (stretched film) via a UV-curable adhesive (thickness after curing: 1 $\mu$m).

The resultant retardation member was bonded to a glass plate (manufactured by Matsunami Glass Ind., Ltd., MICRO SLIDE GLASS, product number: S, thickness: 1.3 mm, 180 mm$\times$250 mm) via the pressure-sensitive adhesive layer having a thickness of 5 um. In this case, the bonding was performed so that the positive C-plate of the retardation member was positioned on a glass plate side.

Next, the protective member was bonded to the retardation member via the pressure-sensitive adhesive layer having a thickness of 5 um to provide a first laminate portion on the glass plate. In this case, the bonding was performed so

that the acrylic film of the protective member was positioned on a retardation member side.

(Production of Absorption-type Polarizer)

An amorphous isophthalic acid-copolymerized polyethylene terephthalate film (thickness: 100 um) having an elongate shape and having a water absorption ratio of 0.75% and a Tg of about 75°C was used as a thermoplastic resin substrate. One surface of the resin substrate was subjected to corona treatment.

A mixture obtained by adding 13 parts by weight of potassium iodide to 100 parts by weight of a PVA-based resin, which had been obtained by mixing polyvinyl alcohol (polymerization degree: 4,200, saponification degree: 99.2 mol%) and acetoacetyl-modified PVA (manufactured by Mitsubishi Chemical Corporation, product name: "GOHSENX Z410") at 9:1, was dissolved in water to prepare a PVA aqueous solution (application liquid).

The PVA aqueous solution was applied to the corona-treated surface of the resin substrate, and was dried at 60°C to form a PVA-based resin layer having a thickness of 13 um. Thus, a laminate was produced.

The resultant laminate was subjected to free-end uniaxial stretching in its longitudinal direction (lengthwise direction) at a ratio of 2.4 times between rolls having different peripheral speeds in an oven at 130°C (in-air auxiliary stretching treatment).

Next, the laminate was immersed in an insolubilizing bath having a liquid temperature of 40°C (aqueous solution of boric acid obtained by blending 100 parts by weight of water with 4 parts by weight of boric acid) for 30 seconds (insolubilizing treatment).

Next, the laminate was immersed in a dyeing bath having a liquid temperature of 30°C (aqueous solution of iodine obtained by blending 100 parts by weight of water with iodine and potassium iodide at a weight ratio of 1:7) for 60 seconds while the concentration of the aqueous solution was adjusted so that the single layer transmittance (Ts) of a polarizer to be finally obtained became 42.0% or more (dyeing treatment).

Next, the laminate was immersed in a cross-linking bath having a liquid temperature of 40°C (aqueous solution of boric acid obtained by blending 100 parts by weight of water with 3 parts by weight of potassium iodide and 5 parts by weight of boric acid) for 30 seconds (cross-linking treatment).

After that, while the laminate was immersed in an aqueous solution of boric acid having a liquid temperature of 70°C (boric acid concentration: 4 wt%, potassium iodide concentration: 5 wt%), the laminate was uniaxially stretched in the longitudinal direction (lengthwise direction) between rolls having different peripheral speeds so that the total stretching ratio became 5.5 times (underwater stretching treatment).

After that, the laminate was immersed in a washing bath having a liquid temperature of 20°C (aqueous solution obtained by blending 100 parts by weight of water with 4 parts by weight of potassium iodide) (washing treatment).

After that, the laminate was brought into contact with a SUS-made heating roll whose surface temperature was kept at 75°C for about 2 seconds while being dried in an oven kept at 90°C (drying shrinkage treatment). The percentage by which the laminate was shrunk in its widthwise direction by the drying shrinkage treatment was 5.2%.

Thus, a polarizer (absorption-type polarizer) having a thickness of 5 um was formed on the resin substrate.

(Second Laminate Portion)

The absorption-type polarizer was bonded to a glass plate (manufactured by Matsunami Glass Ind., Ltd., MICRO SLIDE GLASS, product number: S, thickness: 1.3 mm, 180 mm×250 mm) via the pressure-sensitive adhesive layer having a thickness of 5 um.

Next, a reflection-type polarizing film ("APCF" manufactured by Nitto Denko Corporation) was bonded to the absorption-type polarizer via the pressure-sensitive adhesive layer having a thickness of 5 um so that the reflection axis of the reflection-type polarizing film and the absorption axis of the absorption-type polarizer were arranged parallel to each other.

Next, the protective member was bonded to the reflection-type polarizing film to provide a second laminate portion on the glass plate. In this case, the bonding was performed so that the acrylic film of the protective member was positioned on a reflection-type polarizing film side.

[Example 2]

A first laminate portion and a second laminate portion were obtained in the same manner as in Example 1 except that a pressure-sensitive adhesive layer to be described below was used.

(Formation of Pressure-sensitive Adhesive Layer)

A monomer mixture containing 94.9 parts by weight of butyl acrylate, 5 parts by weight of acrylic acid, and 0.1 part

by weight of 2-hydroxyethyl acrylate was loaded into a four-necked flask including a stirring blade, a temperature gauge, a nitrogen gas introduction tube, and a condenser. Further, 0.3 part by weight of dibenzoyl peroxide serving as a polymerization initiator was loaded into 100 parts by weight of the monomer mixture together with ethyl acetate, and the inside of the flask was purged with nitrogen by introducing a nitrogen gas under gentle stirring. After that, a polymerization reaction was performed for 7 hours while a liquid temperature in the flask was kept at 60°C. Next, ethyl acetate was added to the resultant reaction liquid to adjust its solid content concentration to 30 wt%. Thus, a solution of an acrylic polymer having a weight-average molecular weight (Mw) of 2,200,000 was prepared.

100 Parts by weight of the solid content of the resultant acrylic polymer solution was blended with 0.6 part by weight of a trimethylolpropane/tolylene diisocyanate adduct (product name: CORONATE L, manufactured by Tosoh Corporation) and 0.075 part by weight of a silane coupling agent (product name: KBM-403, manufactured by Shin-Etsu Chemical Co., Ltd.) to prepare an acrylic pressure-sensitive adhesive.

The resultant acrylic pressure-sensitive adhesive was applied to a substrate film. The resultant coating film on the substrate film was dried in an oven. Thus, a pressure-sensitive adhesive layer having a thickness of 15 um and a surface roughness Ra of 16 nm was formed. The drying was performed while an airflow rate in the oven from the inlet of the oven to the center portion of the oven was adjusted within the range of 15 m/min or less.

[Comparative Example 1]

A first laminate portion and a second laminate portion were obtained in the same manner as in Example 2 except that, in the formation of the pressure-sensitive adhesive layer, the airflow rate in the oven was adjusted within the range of 15 m/min or less, and thus a pressure-sensitive adhesive layer having a thickness of 15 μm and a surface roughness Ra of 22 nm was obtained.

[Comparative Example 2]

A first laminate portion and a second laminate portion were obtained in the same manner as in Example 2 except that, in the formation of the pressure-sensitive adhesive layer, the application thickness of the acrylic pressure-sensitive adhesive was changed and the airflow rate in the oven was adjusted within the range of 15 m/min or less, and thus a pressure-sensitive adhesive layer having a thickness of 23 um and a surface roughness Ra of 29 nm was obtained.

An ISC value was measured for the first laminate portion in each of Examples and Comparative Examples with EyeScale-4W manufactured by I System Corporation. Specifically, the in-plane unevenness of each of the first laminate portion and the second laminate portion was calculated as an ISC value in the ISC measurement mode of a 3CCD image sensor based on the specification of the measurement apparatus.

FIG. 4 is a view for describing a method of measuring an ISC value, and is a schematic view of the arrangement of a light source, a measurement sample, a screen, and a CCD camera when seen from above. As illustrated in FIG. 4, a light source L, three first laminate portions **100,** and a screen **S** were arranged in this order, and a transmission image projected on the screen **S** was measured with a CCD camera **C.**

An assembly formed by arranging the three first laminate portions **100** was used as a measurement sample. The three first laminate portions **100** were arranged so as to be spaced apart from each other by from 0.001 mm to 3 mm. As illustrated in FIG. **4,** the first laminate portion **100** positioned nearest the light source **L** was arranged so that an adjacent glass plate **G** was positioned on a light source **L** side. The first laminate portion 100 positioned in the middle was arranged so that an adjacent glass plate **G** was positioned on a screen **S** side. The first laminate portion **100** positioned nearest the screen **S** was arranged so that an adjacent glass plate **G** was positioned on the light source **L** side.

The arrangement was performed so that a distance from the light source **L** to the measurement sample in an X-axis direction became from 10 cm to 60 cm. The arrangement was performed so that a distance from the light source **L** to the screen **S** in the X-axis direction became from 70 cm to 130 cm. The arrangement was performed so that a distance from the CCD camera **C** to the measurement sample in a Y-axis direction became from 3 cm to 30 cm. The arrangement was performed so that a distance from the CCD camera **C** to the screen **S** in the X-axis direction became from 70 cm to 130 cm.

In FIG. **4,** details of the first laminate portion are omitted for ease of viewing of the drawing. The measurement results are shown in Table 1.

Appearance (lens-transmitted light) was evaluated for each of Examples and Comparative Examples with an optical lens (manufactured by Thorlabs, Inc., product name: "LA1145") and a point light source (manufactured by Hamamatsu Photonics K.K., model number: "L8425-01").

Specifically, the first laminate portion and the second laminate portion each cut into a 45 mmφ circle were laminated in this order on the flat side of the optical lens while a slight pressure was applied with a hand roller so that foreign matter, an air bubble, or a deformation streak did not enter a surface. Next, defoaming was performed with a pressurization defoaming apparatus (autoclave) in order to remove the influence of fine air bubbles. Defoaming conditions were set to 50°C, 0.5 MPa, and 30 minutes. After the defoaming, the resultant was allowed to cool at room temperature for 30 minutes

or more to provide a measurement sample.

The point light source, the optical lens (measurement sample), and the screen were arranged in this order, and the appearance was evaluated by projecting light from the point light source on the screen through the optical lens. In this case, the optical lens was held with a holder at a position where the light from the point light source entered from the convex side of the lens. A distance from the point light source to the screen was set to 1,050 mm, and a distance from the optical lens to the screen was set to 130 mm.

The light projected on the screen through the optical lens was visually observed, and the appearance was evaluated by evaluation criteria to be described below. The measurement results are shown in Table 1.

(Evaluation Criteria)

·Satisfactory: No corrugation or waviness is visible.
·Poor: Corrugation and waviness are visible.

Table 1

| | | Example 1 | Example 2 | Comparative Example 1 | Comparative Example 2 |
|---|---|---|---|---|---|
| Pressure-sensitive adhesive layer | Thickness (μm) | 5 | 15 | 15 | 23 |
| | Surface roughness (nm) | 12 | 16 | 22 | 29 |
| ISC value | | 59 | 63 | 110 | 175 |
| Appearance | | Satisfactory | Satisfactory | Poor | Poor |

The present invention is not limited to the above-mentioned embodiments, and various modifications may be made thereto. For example, the configurations described in the above-mentioned embodiments may each be replaced by substantially the same configuration, a configuration having the same action and effect, or a configuration that can achieve the same object.

Industrial Applicability

The lens unit according to the embodiment of the present invention may be used in, for example, a display body such as a pair of VR goggles.

Reference Signs List

**2** display system, **4** lens unit, **12** display element, **14** reflection-type polarizing member, **16** first lens portion, **18** half mirror, **20** first retardation member, **22** second retardation member, **24** second lens portion, **28** absorption-type polarizing member, **30** third retardation member, **31** first protective member, **32** second protective member, **41** pressure-sensitive adhesive layer, **42** pressure-sensitive adhesive layer, **43** pressure-sensitive adhesive layer, **44** pressure-sensitive adhesive layer, **45** pressure-sensitive adhesive layer, **46** pressure-sensitive adhesive layer, **100** first laminate portion, **200** second laminate portion.

## Claims

**1.** A lens unit to be used in a display system configured to display an image to a user, the lens unit comprising:

a reflection-type polarizing member configured to reflect light, which has been emitted to a front side from a display surface of a display element configured to display the image, and has passed through a polarizing member and a first λ/4 member;
a first lens portion arranged on an optical path between the display element and the reflection-type polarizing

member;
a half mirror arranged between the display element and the first lens portion, the half mirror being configured to transmit the light emitted from the display element and to reflect the light reflected by the reflection-type polarizing member toward the reflection-type polarizing member;
a second lens portion arranged on the front side of the reflection-type polarizing member; and
a second λ/4 member arranged on an optical path between the half mirror and the reflection-type polarizing member,
wherein an assembly formed by arranging three first laminate portions each including the second λ/4 member and at least one pressure-sensitive adhesive layer has an ISC value of 100 or less.

2. The lens unit according to claim 1, wherein the lens unit comprises a second laminate portion including the reflection-type polarizing member.

3. The lens unit according to claim 2, wherein the first laminate portion and the second laminate portion are arranged so as to be spaced apart from each other.

4. The lens unit according to claim 2, wherein the second laminate portion includes an absorption-type polarizing member arranged between the reflection-type polarizing member and the second lens portion.

5. The lens unit according to claim 2, wherein the second laminate portion includes a third λ/4 member arranged between the reflection-type polarizing member and the second lens portion.

6. The lens unit according to claim 1, wherein the first laminate portion includes a first protective member arranged on the front side of the second λ/4 member.

7. The lens unit according to claim 1, wherein the number of the pressure-sensitive adhesive layers in the first laminate portion is three or less.

8. The lens unit according to claim 1, wherein a thickness of each of the pressure-sensitive adhesive layers in the first laminate portion is 20 um or less.

9. The lens unit according to claim 1, wherein a surface roughness Ra of each of the pressure-sensitive adhesive layers in the first laminate portion is 20 nm or less.

10. The lens unit according to claim 1, wherein each of the pressure-sensitive adhesive layers in the first laminate portion is a single-layer body.

11. The lens unit according to claim 1, wherein the first lens portion and the half mirror are integrated with each other.

12. A display body, comprising the lens unit of any one of claims 1 to 11.

13. A display method, comprising the steps of:

passing light representing an image, which has been emitted through a polarizing member and a first λ/4 member, through a half mirror and a first lens portion;
passing the light, which has passed through the half mirror and the first lens portion, through a second λ/4 member;
reflecting the light, which has passed through the second λ/4 member, toward the half mirror with a reflection-type polarizing member;
enabling the light, which has been reflected by the reflection-type polarizing member and the half mirror, to penetrate through the reflection-type polarizing member with the second λ/4 member; and
passing the light, which has penetrated through the reflection-type polarizing member, through a second lens portion,
wherein an assembly formed by arranging three first laminate portions each including the second λ/4 member and at least one pressure-sensitive adhesive layer has an ISC value of 100 or less.

FIG. 1

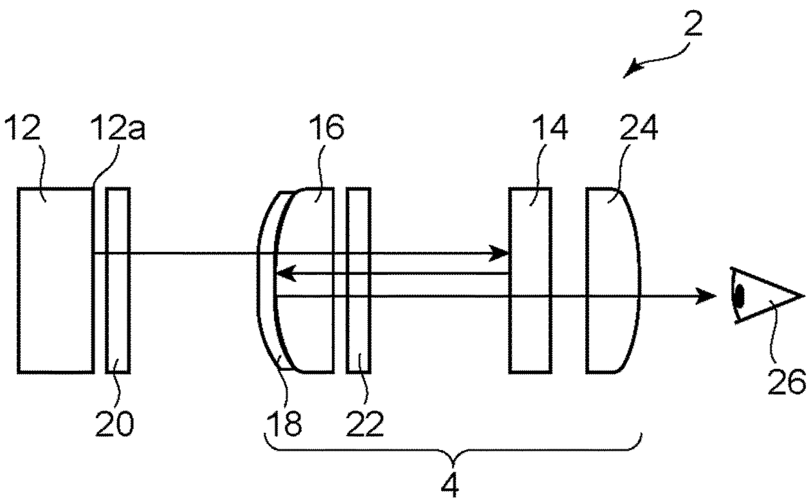
2
12
12a
16
14
24
20
18
22
26
4

FIG. 2

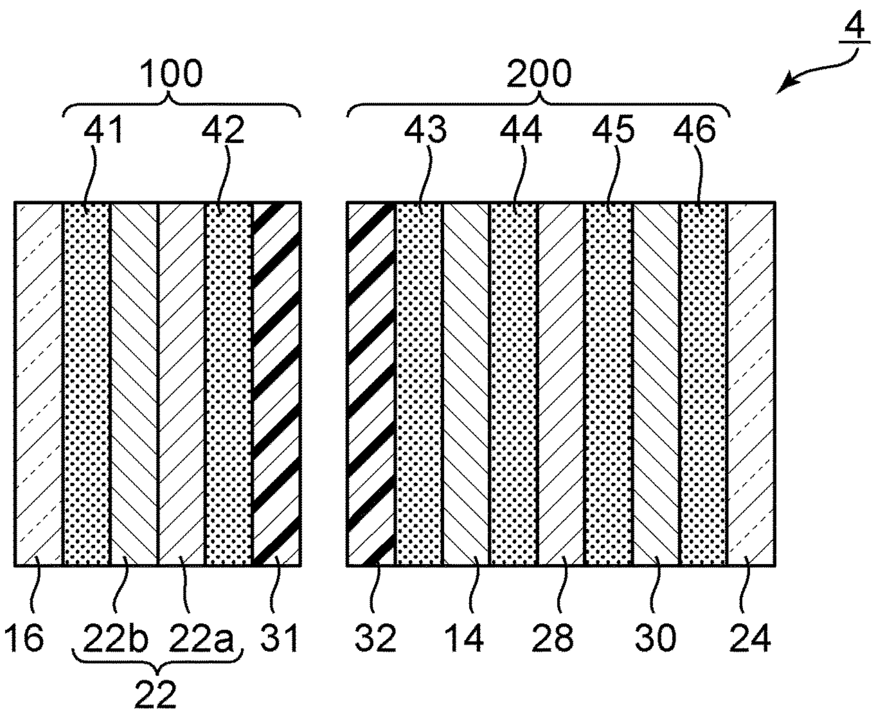
4
100
200
41
42
43
44
45
46
16
22b
22a
31
32
14
28
30
24
22

FIG. 3

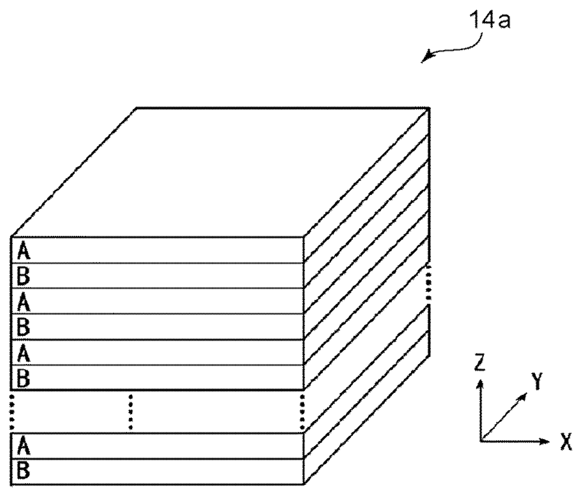


FIG. 4

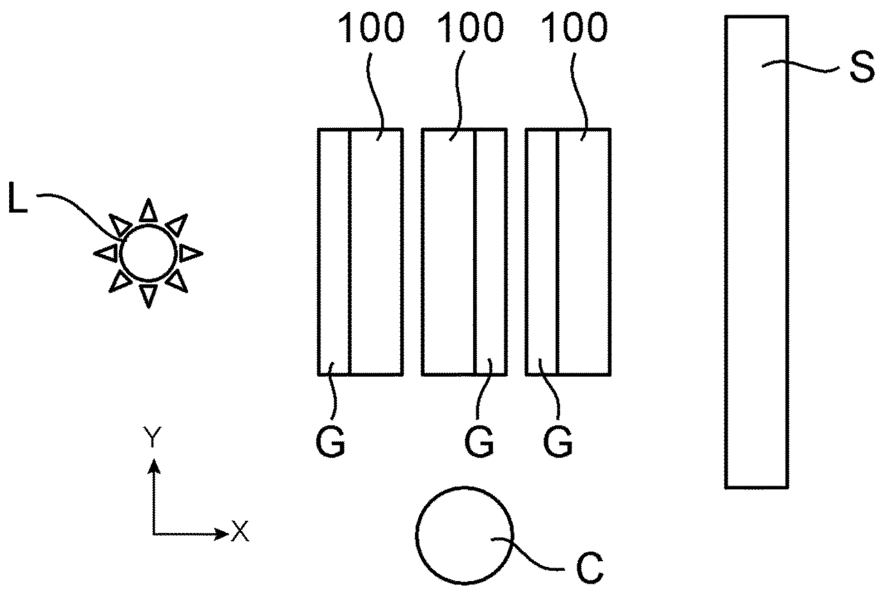

## INTERNATIONAL SEARCH REPORT

International application No. **PCT/JP2023/008810**

**A. CLASSIFICATION OF SUBJECT MATTER**

***G02B 27/02***(2006.01)i; ***G02B 3/00***(2006.01)i; ***G02B 5/00***(2006.01)i; ***G02B 5/08***(2006.01)i; ***G02B 5/30***(2006.01)i; ***G02B 13/00***(2006.01)i; ***G02B 17/08***(2006.01)i; ***G02C 7/00***(2006.01)i; ***G02F 1/13***(2006.01)i; ***G02F 1/13363***(2006.01)i; ***G02F 1/1337***(2006.01)i; ***G09F 9/00***(2006.01)i; ***H04N 5/64***(2006.01)i; ***H04N 5/66***(2006.01)i; ***H04N 13/344***(2018.01)i; ***H04N 13/346***(2018.01)i; ***H05B 33/02***(2006.01)i; ***H05B 33/10***(2006.01)i; ***H05B 33/24***(2006.01)i; ***H10K 50/00***(2023.01)i; ***H10K 59/00***(2023.01)i

FI: G02B27/02 Z; G02B3/00 Z; G02B5/00 Z; G02B5/08 D; G02B5/30; G02B13/00; G02B17/08; G02C7/00; G02F1/13 505; G02F1/13363; G02F1/1337; G09F9/00 313; H04N5/64 511A; H04N5/66 Z; H04N13/344; H04N13/346; H05B33/02; H05B33/10; H05B33/14 A; H05B33/24; H10K59/00

According to International Patent Classification (IPC) or to both national classification and IPC

**B. FIELDS SEARCHED**

Minimum documentation searched (classification system followed by classification symbols)

G02B27/02; G02B27/01; G02B3/00; G02B5/00; G02B5/08; G02B5/30; G02B13/00; G02B17/08; G02C7/00; G02F1/13; G02F1/13363; G02F1/1337; G09F9/00; H04N5/64; H04N5/66; H04N13/344; H04N13/346; H05B33/02; H05B33/10; H05B33/24; H10K50/00; H10K59/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2021-531497 A (3M INNOVATIVE PROPERTIES COMPANY) 18 November 2021 (2021-11-18) paragraphs [0007]-[0078], fig. 3, 6, 7 | 1-13 |
| Y | JP 2007-138147 A (NITTO DENKO CORP) 07 June 2007 (2007-06-07) paragraphs [0016]-[0240], fig. 1 | 1-13 |
| Y | JP 2017-151131 A (FUJIFILM CORP) 31 August 2017 (2017-08-31) paragraph [0095], fig. 5 | 6 |

☐ Further documents are listed in the continuation of Box C.　☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/008810**

| Patent document cited in search report | Publication date (day/month/year) | Patent family member(s) | Publication date (day/month/year) |
|---|---|---|---|
| JP 2021-531497 A | 18 November 2021 | US 2021/0215865 A1<br>paragraphs [0021]-[0090], fig. 3, 6, 7<br>WO 2020/012416 A1<br>CN 112400125 A<br>KR 10-2021-0031469 A | |
| JP 2007-138147 A | 07 June 2007 | US 2009/0042004 A1<br>paragraphs [0025]-[0249], fig. 1<br>WO 2007/046365 A1<br>KR 10-2008-0049124 A<br>CN 101283069 A<br>TW 200720388 A | |
| JP 2017-151131 A | 31 August 2017 | WO 2017/145580 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021103286 A
- JP 2014010291 A
- JP 2014026266 A
- JP 2015212816 A
- JP 2015212817 A
- JP 2015212818 A
- JP 2006163343 A
- JP 2006178389 A
- WO 2018123551 A1
- JP 2002333642 A
- JP 2012073580 A
- JP 6470455 B